# EUROPEAN PATENT SPECIFICATION

(11) **EP 1 587 183 B1**
(45) Date of publication and mention of the grant of the patent: **27.08.2008**
(21) Application number: 05007684.3
(22) Date of filing: 07.04.2005
(51) Int. Cl.: H01R 43/24, B29C 45/14

(54) **An insert-molded article and a production method for insert-molded article**
Gegenstand mit eingegossenem Einsatz und Herstellungsverfahren
Article moule avec insert et méthode de fabrication

(30) Priority: 13.04.2004 JP 2004117838
(43) Date of publication of application: 19.10.2005
(73) Proprietor: Sumitomo Wiring Systems, Ltd., Yokkaichi-City, Mie, 510-8503 (JP)
(72) Inventor: Takanashi, Hitoshi, Yokkaichi-city Mie 510-8503 (JP)
(74) Representative: Müller-Boré & Partner Patentanwälte

(56) References cited:
- DE-A1- 19 504 828
- US-A1- 2004 002 260
- US-B1- 6 294 851

## Description

The present invention relates to an insert-molded article and a production method for insert-molded article.

There has been known a technology of forming a primary molded article using an electrically conductive member made of a metal as an insert and then forming a secondary molded article using the primary molded article as an insert (for example, see Japanese Unexamined Patent Publication No. H09-300401). According to this technology, there is a merit of being able to precisely position the electrically conductive member in a mold for the secondary molding since the primary molded article can be set in the mold with a supporting portion formed during the primary molding held in contact with the inner wall surface of the mold.

In the above case, an end surface of the supporting portion of the primary molded article is exposed at the outer surface of the secondary molded article after the insert molding. Thus, there is a possibility that moisture enters a tiny clearance created at an interface of the primary molded article and the secondary molded article from the periphery of the end surface of the supporting portion. Particularly in an ECU casing having a printed circuit board accommodated therein or the like, there has been a problem of being unable to maintain watertightness in the casing due to the water entrance from the exposed end surface if the end surface of the supporting portion is exposed at the outer surface of the casing.

The present invention was developed in view of the above problem and an object thereof is to improve operability, in particular ensure watertightness.

This object is solved according to the invention by the features of the independent claims. Preferred embodiments of the invention are subject of the dependent claims.

According to the invention, there is provided an insert-molded article provided with a casing formed by insert molding using an inner portion holding at least one insert member, as an insert, wherein:
the inner portion includes at least one interlocking portion to be hooked (i.e. interlocked or engaged) in a mold for molding the casing and is so positioned and supported in the mold by the presence of the interlocking portion as to at least partly project from an inner wall surface of the mold,
the interlocking portion is located at or on the inner surface of the casing, and
the casing is formed by at least partly covering the inner portion substantially excluding the interlocking portion by a resin portion.

### Preferably, the insert member may be at least one metal member.

The interlocking portion of the inner portion is hooked (i.e. interlocked or engaged) in the mold for molding the casing, whereby the inner portion is so positioned and supported in the mold as to at least partly project from the inner wall surface of the mold, and insert molding is carried out in this state, thereby forming the casing in which the interlocking portion is located at the inner surface thereof and the inner portion substantially excluding the interlocking portion is at least partly covered by the resin portion. Thus, an end surface of the interlocking portion is not exposed at the outer surface of the casing. Therefore, the entrance of water from the outer surface of the casing can be advantageously prevented, and watertightness in the casing can be maintained.

According to a preferred embodiment of the invention, the interlocking portion is formed to project substantially toward the inside of the casing from the inner surface of the casing.

Since the interlocking portion is formed to project substantially toward the inside of the casing from the inner surface of the casing, insert molding can be carried out with the interlocking portion tightly held between an upper and a lower molds of the mold, thereby enabling the construction of the mold to be simplified.

Preferably, the insert (preferably metal) member includes at least one busbar electrically connectable with a conductor portion of a printed circuit board or an electrical or electronic component at least partly accommodated in the casing, and/or the interlocking portion is made of a synthetic resin material.

Since the metal member is the electrically conductive busbar electrically connectable with the conductor portion of the printed circuit board or the electronic or electronic component accommodated in the casing and/or the interlocking portion is made of the synthetic resin, the busbar can be insulated to prevent an occurrence of a leakage.

Further preferably, one of the interlocking portion and the mold comprise a recess and the other of the interlocking portion and the mold comprise a projection engageable with the recess.

Still further preferably, one or more recesses having substantially L-shaped cross sections are formed at one or more corner portions of the inner portion.

Most preferably, two substantially L-shaped recesses are formed at a first corner and a second corner substantially diagonally opposite to the first corner of the inner portion.

According to the invention, there is further provided a production method for insert-molded article provided with a casing formed by insert molding using an inner portion holding at least one insert member as an insert, comprising the following steps:
hooking an interlocking portion provided at the inner portion in a mold for molding the casing, whereby positioning and supporting the inner portion so in the mold as to project from an inner wall surface of the mold, and
carrying out insert molding in this state, thereby forming the casing in which the interlocking portion is located at the inner surface thereof and the inner portion substantially excluding the interlocking portion is at least partly covered by a resin portion.

According to a preferred embodiment of the invention, there is provided a production method for insert-molded article provided with a casing formed by insert molding using an inner portion holding a metal member as an insert, characterized in that:
an interlocking portion provided at the inner portion is hooked in a mold for molding the casing, whereby the inner portion is so positioned and supported in the mold as to project from an inner wall surface of the mold, and
insert molding is carried out in this state, thereby forming the casing in which the interlocking portion is located at the inner surface thereof and the inner portion excluding the interlocking portion is covered by a resin portion.

Preferably, in the hooking step a recess provided at one of the interlocking portion and the mold is engaged with a projection provided at the other of the interlocking portion and the mold.

Most preferably, in or during the insert molding step the interlocking portion is tightly held between a first mold member and second mold member and/or at least partly projects in a cavity where molding material is at least partly filled.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a plan view of an ECU casing according to one embodiment of the invention,
FIG. 2 is an enlarged plan view showing an essential portion of an embedded state of a busbar,
FIG. 3 is a section showing a state before an inner portion is set in a mold,
FIG. 4 is a section showing a state where the inner portion is set in the mold,
FIG. 5 is a section showing a state where molten resin is filled into a cavity, and
FIG. 6 is a section showing a state where the mold is opened to enable the inner portion to be taken out.

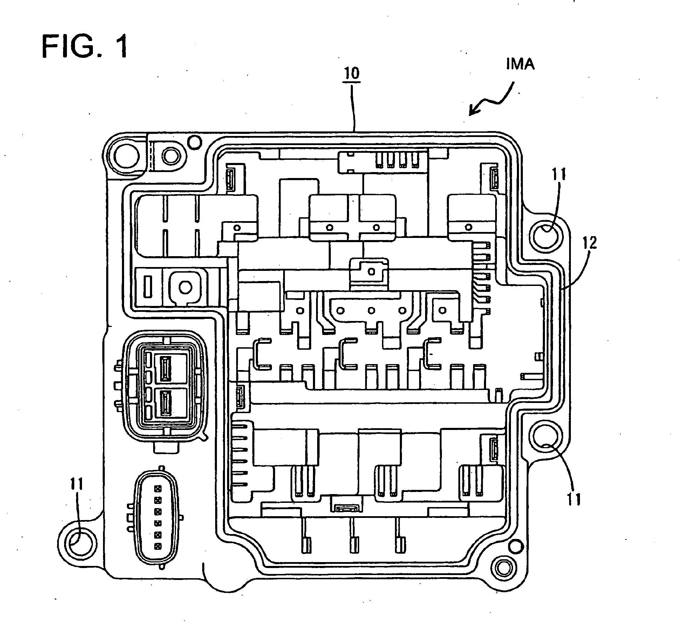

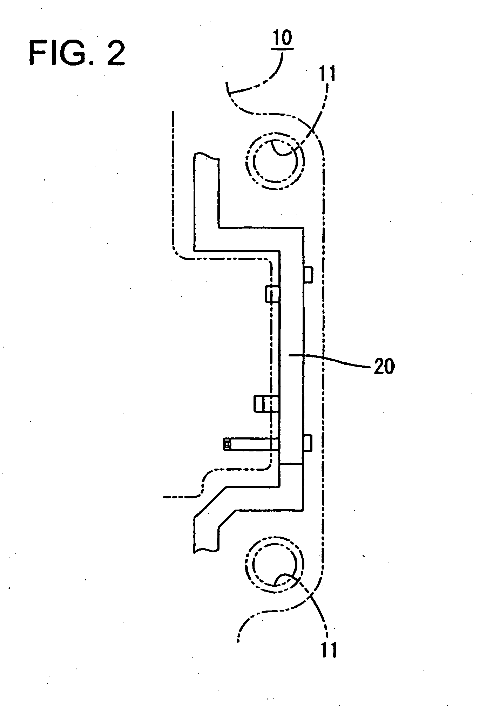

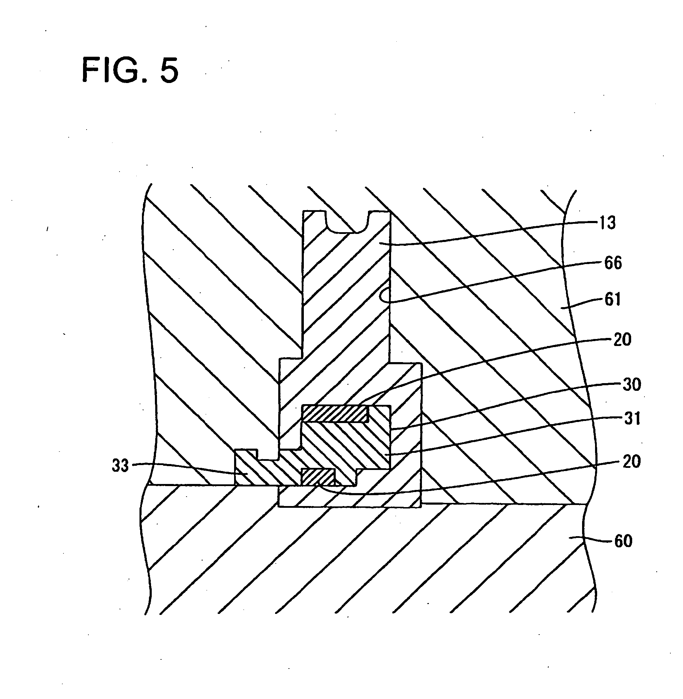

One preferred embodiment of the present invention is described with reference to FIGS. 1 to 6. An insert-molded article IMA according to this embodiment is one application of the present invention to an electronic control unit (ECU) having a printed circuit board at least partly accommodated inside a casing 10. FIG. 1 shows the entire casing 10.

The casing 10 is made e.g. of a synthetic resin preferably substantially into a box having an open upper or lateral surface, and the printed circuit board is at least partly accommodated and a plurality of busbars are arranged therein.

An unillustrated cover is or is to be mounted at or on an opening of the casing 10 to ensure watertightness in the casing 10. Further, one or more mount holes 11 preferably in the form of through holes used to mount the casing 10 on a body of a vehicle are formed at specified (predetermined or predeterminable) positions at or on the outer periphery of the casing 10, and the casing 10 is to be mounted on the body by bolts inserted through these mount holes 11.

One or more (preferably substantially strip-shaped) busbars or conductors 20 are at least partly embedded at specified (predetermined or predeterminable) parts of side walls 12 of the casing 10 along the wall surfaces of the side walls 12. The busbar 20 at least partly embedded in a bulging portion of the lateral (right) side wall 12 shown in FIG. 1 is crank-shaped and ends thereof at least partly project into the casing 10 to be connectable with the printed circuit board and electric or electronic components. Upon molding such a portion, an inner portion 30 having the one or more busbars 20 as inserts is used as an insert.

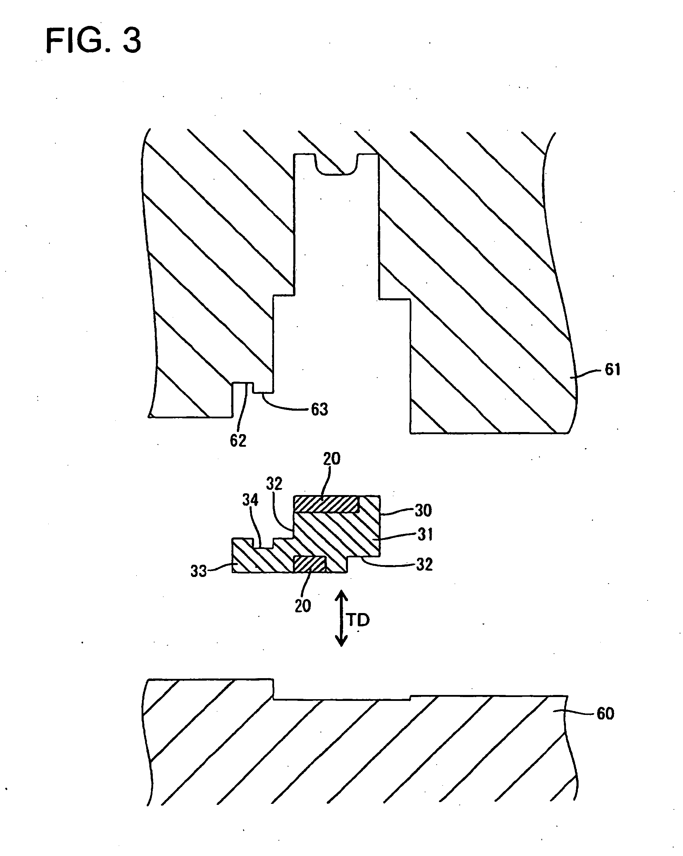

The inner portion 30 is, as shown in FIG. 3, comprised of two busbars 20 spaced apart by a specified (predetermined or predeterminable) distance along thickness direction TD (or a direction substantially normal to the longitudinal direction of the busbars 20) and a holding portion 31 made e.g. of a synthetic resin for covering the facing surfaces of the respective busbars 20, wherein the respective busbars 20 are held at a specified (predetermined or predeterminable) spacing or distance by the holding portion 31. One or more recesses 32 having substantially L-shaped cross sections (or each opening to two lateral sides of the holding portion 31) are formed at a first (right lower) corner and a second (left upper) corner (substantially diagonally opposite to the first corner) of the holding portion 31 shown in FIG. 3. A resin portion 13 (to be described later) of the casing 10 at least partly enters these recesses 32 to enhance an engaging force with the resin portion 13, so that the inner portion 30 does not come out of the casing 10. An interlocking portion 33 made of a synthetic resin is so formed as to be substantially continuous with the holding portion 31 at the lateral (left) side of the busbar 20 disposed at a lower side in FIG. 3.

The interlocking portion 33 is formed to substantially horizontally project from its base end toward its leading end, and can be hooked in a mold for secondary molding, and the inner portion 30 is so positioned and supported in the mold 61 as to project from the inner wall surface of the mold 61 by the engagement of the interlocking portion 33 and the mold 61. A recess 34 is formed at the base end or extending portion of the interlocking portion 33, and the inner portion 30 is prevented from lateral loose movements by the engagement of this recess 34 and a projection 63 formed in the mold 61. In other words, the recess 34 is so formed in the lateral (upper) surface of the interlocking portion 33 as to be open upward or laterally and have a substantially U-shaped cross section, and is closely engageable with the projection 63.

The casing 10 is formed by insert molding using the above inner portion 30 as an insert such that the inner portion 30 excluding the interlocking portion 33 is at least partly, preferably substantially completely covered by the resin portion 13 (made of the preferably same synthetic resin as the holding portion 31). Here, the interlocking portion 33 is located at the inner surface of the casing 10 and projects toward the inside of the casing 10 from the inner surface of the casing 10 with the recess 34 as a border.

Next, the construction of the mold for secondary molding is described. This mold is comprised of a lower mold 60 and an upper mold 61 as shown in FIG. 3. The upper mold 61 is provided with a receiving portion 62 recessed substantially in conformity with the shape of the interlocking portion 33, and the aforementioned projection 63 is provided on the inner wall surface of this receiving portion 62 to project downward or laterally. The interlocking portion 33 is engageable with the receiving portion 62 as the mold 61, 62 is closed. As being engaged with the receiving portion 62, the interlocking portion 33 is tightly held between the upper mold 61 and the lower mold 60 and projects in a cavity 66.

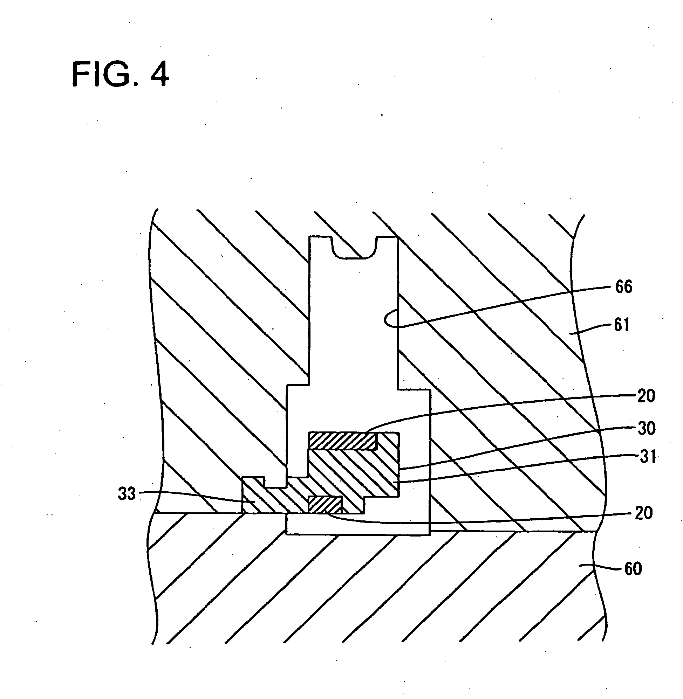

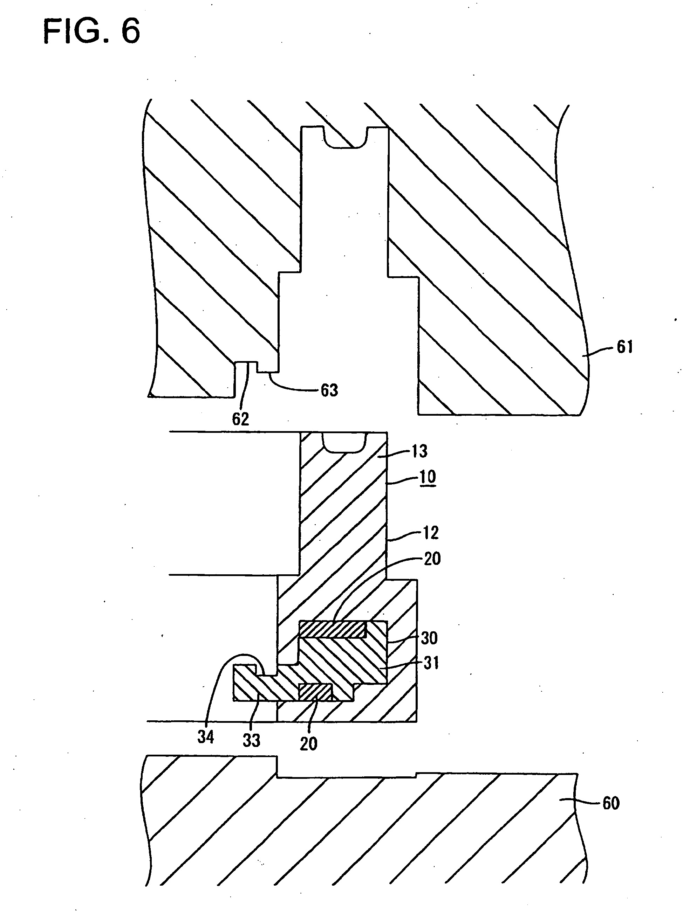

Next, a method for producing the casing 10 according to this embodiment is described. First, the inner portion 30 is formed by insert molding using the one or more busbars 20 as inserts. Subsequently, as shown in FIGS. 3 and 4, the lower and upper molds 60, 61 are brought to the inner portion 30, thereby closing the mold to at least partly fit the interlocking portion 33 in the receiving portion 62. As the mold closing is completed, the interlocking portion 33 is tightly held between the upper and lower molds 61, 60 and the recess 34 of the interlocking portion 33 and the projection 63 of the upper mold 61 are engaged with each other, with the result that the inner portion 30 is so positioned and supported as to project from the inner wall surface of the mold while being prevented from lateral and vertical loose movements. Molten resin is injected to at least partly fill the cavity 66 of the mold in this state. When the molten resin is cooled and solidified or cured and the mold is opened, the substantially entire casing 10 including a side wall portion shown in FIG. 6 is obtained. The casing 10 as a finished article is such that the interlocking portion 33 is exposed at the inner surface thereof and the holding portion 31 is preferably substantially entirely covered by the resin portion 13.

As described above, according to this embodiment, the interlocking portion 33 is hooked in or interlocked with the mold to thereby position and support the inner portion 30 in the mold in such a manner as to project from the inner wall surface of the mold during the insert molding using the inner portion 30 as an insert. Thus, the preferably substantially entire inner portion 30 excluding the interlocking portion 33 can be covered by the resin portion 13. At this time, since the interlocking portion 33 is located at the inner surface of the casing 10, an end surface or the like of the interlocking portion 33 is not exposed at the outer surface of the casing 10, wherefore the entrance of water from the outside of the casing 10 can be securely prevented. As a result, watertightness in the casing 10 can be maintained. Further, an occurrence of a leakage can be prevented.

Further, since the interlocking portion 33 is formed to project toward the inside of the casing 10 from the inner surface of the casing 10, insert molding can be carried out with the interlocking portion 33 tightly held between the upper and lower molds 61, 60. Therefore, the construction of the mold can be simplified.

Accordingly, to ensure or enhance watertightness in a casing, a casing 10 is formed by insert molding using an inner portion 30 holding one or more busbars or conductors 20 as an insert. The inner portion 30 includes an interlocking portion 33 to be hooked in a mold for molding the casing 10, and is so positioned and supported in the mold by the presence of the interlocking portion 33 as to project from the inner wall surface of the mold. The interlocking portion 33 is formed to project substantially toward the inside of the casing 10 from the inner surface of the casing 10. The casing 10 is formed by at least partly covering the inner portion 30 substantially excluding the interlocking portion 33 by a resin portion 13.

### <Other Embodiments>

The present invention is not limited to the above described and illustrated embodiment. For example, the following embodiments are also embraced by the technical scope of the present invention as defined by the claims. Beside the following embodiments, various changes can be made without departing from the scope of the present invention as defined by the claims.

(1) Although the inner portion holds the busbars in the foregoing embodiment, the inner portion may hold mere metal member(s) other than the busbars according to the present invention.
(2) Although in the above embodiment only one interlocking portion 33 is provided, it should be understood that two or more interlocking portions may be provided for correctly positioning or holding the inner portion during the molding process.

### LIST OF REFERENCE NUMERALS

- 10: casing
- 13: resin portion
- 20: busbar
- 30: inner portion
- 33: interlocking portion
- 60: lower mold
- 61: upper mold
- 62: receiving portion

## Claims

1. An insert-molded article (IMA) provided with a casing (10) formed by insert molding using an inner portion (30) holding at least one insert member (20) as an insert, **characterised in that**
the inner portion (30) includes at least one interlocking portion (33) to be hooked in a mold (60, 61) for molding the casing (10) and is so positioned and supported in the mold (60, 61) by the presence of the interlocking portion (33) as to project from an inner wall surface of the mold (60, 61),
the interlocking portion (33) is located at the inner surface of the casing (10), and
the casing (10) is formed by at least partly covering the inner portion (30) substantially excluding the interlocking portion (33) by a resin portion.

2. An insert-molded article according to claim 1, wherein the interlocking portion (33) is formed to project substantially toward the inside of the casing (10) from the inner surface of the casing (10).

3. An insert-molded article according to one or more of the preceding claims, wherein the insert member (20) includes a busbar (20) electrically connectable with a conductor portion of a printed circuit board or an electrical or electronic component at least partly accommodated in the casing (10).

4. An insert-molded article according to one or more of the preceding claims, wherein the interlocking portion (33) is made of a synthetic resin material.

5. An insert-molded article according to one or more of the preceding claims, wherein one of the interlocking portion (33) and the mold (60, 61) comprise a recess (34) and the other of the interlocking portion (33) and the mold (60, 61) comprise a projection (63) engageable with the recess (34).

6. An insert-molded article according to one or more of the preceding claims, wherein one or more recesses (32) having substantially L-shaped cross sections are formed at one or more corner portions of the inner portion (30).

7. An insert-molded article according to claim 6, wherein two substantially L-shaped recesses (32) are formed at a first corner and a second corner substantially diagonally opposite to the first corner of the inner portion (30).

8. A production method for insert-molded article (IMA) provided with a casing (10) formed by insert molding using an inner portion (30) holding at least one insert member (20) as an insert, comprising the following steps:
hooking an interlocking portion (33) provided at the inner portion (30) in a mold (60, 61) for molding the casing (10), whereby positioning and supporting the inner portion (30) so in the mold (60, 61) as to project from an inner wall surface of the mold (60, 61), and
carrying out insert molding in this state, thereby forming the casing (10) in which the interlocking portion (33) is located at the inner surface thereof and the inner portion (30) substantially excluding the interlocking portion (33) is at least partly covered by a resin portion.

9. A method according to claim 8, wherein in the hooking step a recess (34) provided at one of the interlocking portion (33) and the mold (60, 61) is engaged with a projection (63) provided at the other of the interlocking portion (33) and the mold (60, 61).

10. A method according to claim 8 or 9, wherein in or during the insert molding step the interlocking portion (33) is tightly held between a first mold member (60) and second mold member (61) and/or at least partly projects in a cavity (66) where molding material is at least partly filled.

## Patentansprüche

1. Gegenstand mit eingegossenem Einsatz (IMA), welcher mit einem Gehäuse (10) versehen ist, welches durch ein Einsetzformen bzw. -gießen unter Verwendung eines inneren Abschnitts (30) gebildet ist bzw. wird, welcher wenigstens ein Einsatzglied (20) als einen Einsatz hält, **dadurch gekennzeichnet, daß**
der innere Abschnitt (30) wenigstens einen ineinander verriegelnden Abschnitt (33) beinhaltet, welcher in einer Form (60, 61) für ein Formen bzw. Gießen des Gehäuses (10) einzuhaken ist, und durch das Vorhandensein des ineinander verriegelnden Abschnitts (33) positioniert und in der Form (60, 61) abgestützt ist, um von einer inneren Wandoberfläche der Form (60, 61) vorzuragen,
der ineinander verriegelnde Abschnitt (33) an der inneren Oberfläche des Gehäuses (10) angeordnet ist, und
das Gehäuse (10) durch ein wenigstens teilweises Abdecken des inneren Abschnitts (30) im wesentlichen unter Ausnahme des ineinander verriegelnden Abschnitts (33) durch einen Harzabschnitt gebildet ist bzw. wird.

2. Gegenstand mit eingegossenem Einsatz nach Anspruch 1, wobei der ineinander verriegelnde Abschnitt (33) ausgebildet ist, um im wesentlichen in Richtung zu dem Inneren des Gehäuses (10) von der inneren Oberfläche des Gehäuses (10) vorzuragen.

3. Gegenstand mit eingegossenem Einsatz nach einem oder mehreren der vorangehenden Ansprüche, wobei das Einsatzglied (20) eine Sammelschiene (20) beinhaltet, welche elektrisch mit einem Leiterabschnitt einer Leiterplatte oder einer elektrischen oder elektronischen Komponente verbindbar ist, welche wenigstens teilweise in dem Gehäuse (10) aufgenommen ist.

4. Gegenstand mit eingegossenem Einsatz nach einem oder mehreren der vorangehenden Ansprüche, wobei der ineinander verriegelnde Abschnitt (33) aus einem synthetischen bzw. Kunstharzmaterial hergestellt ist.

5. Gegenstand mit eingegossenem Einsatz nach einem oder mehreren der vorangehenden Ansprüche, wobei einer des ineinander verriegelnden Abschnitts (33) und der Form (60, 61) eine Vertiefung bzw. Aussparung (34) umfaßt und der andere des ineinander verriegelnden Abschnitts (33) und der Form (60, 61) einen Vorsprung bzw. eine Erhebung (63) umfaßt, welche(r) mit der Vertiefung (34) in Eingriff bringbar ist.

6. Gegenstand mit eingegossenem Einsatz nach einem oder mehreren der vorangehenden Ansprüche, wobei eine oder mehrere Vertiefung(en) (32), welche einen im wesentlichen L-förmigen Querschnitt aufweist (aufweisen), an einem oder mehreren Eckabschnitt(en) des inneren Abschnitts (30) ausgebildet ist bzw. sind.

7. Gegenstand mit eingegossenem Einsatz nach Anspruch 6, wobei zwei im wesentlichen L-förmige Vertiefungen (32) an einem ersten Eck und einem zweiten Eck im wesentlichen diagonal gegenüberliegend zu dem ersten Eck des inneren Abschnitts (30) ausgebildet sind.

8. Herstellungsverfahren für einen Gegenstand mit eingegossenem Einsatz (IMA), welcher mit einem Gehäuse (10) versehen wird, welches durch ein Einsetzformen unter Verwendung eines inneren Abschnitts (30) gebildet wird, welcher wenigstens ein Einsatzglied (20) als einen Einsatz hält, umfassend die folgenden Schritte:
Einhaken eines ineinander verriegelnden Abschnitts (33), welcher an dem inneren Abschnitt (30) vorgesehen bzw. zur Verfügung gestellt wird, in einer Form (60, 61) für ein Formen bzw. Gießen des Gehäuses (10), wodurch der innere Abschnitt (30) in der Form (60, 61) positioniert und abgestützt wird, um von einer inneren Wandoberfläche der Form (60, 61) vorzuragen, und
Ausführen eines Einsetzformens in diesem Zustand, wodurch das Gehäuse (10) gebildet wird, in welchem der ineinander verriegelnde Abschnitt (33) an der inneren Oberfläche davon angeordnet wird und der innere. Abschnitt (30) im wesentlichen unter Ausnahme des ineinander verriegelnden Abschnitts (33) wenigstens teilweise durch einen Harzabschnitt abgedeckt wird.

9. Verfahren nach Anspruch 8, wobei in dem Einhakschritt eine Vertiefung bzw. Aussparung (34), welche an einem des ineinander verriegelnden Abschnitts (33) und der Form (60, 61) vorgesehen bzw. zur Verfügung gestellt wird, mit einem Vorsprung bzw. einer Erhebung (63) in Eingriff gebracht wird, welche(r) an dem anderen des ineinander verriegelnden Abschnitts (33) und der Form (60, 61) vorgesehen bzw. zur Verfügung gestellt wird.

10. Verfahren nach Anspruch 8 oder 9, wobei in dem oder während des Einsetzgießschritt(s) der ineinander verriegelnde Abschnitt (33) fest zwischen einem ersten Formglied (60) und einem zweiten Formglied (61) gehalten wird und/oder wenigstens teilweise in einen Hohlraum (66) vorragt,
wo Form- bzw. Gießmaterial wenigstens teilweise eingefüllt wird.

## Revendications

1. Article moulé avec insert (IMA) prévu avec un boîtier (10) formé par le moulage d'un insert en utilisant une partie intérieure (30) qui maintient au moins un élément d'insert (20) comme un insert, **caractérisée en ce que :**
la partie intérieure (30) inclut au moins une partie de verrouillage réciproque (33) qui doit être accrochée dans un moule (60, 61) pour le moulage du boîtier (10) et qui est positionnée et soutenue dans le moule (60, 61) par la présence de la partie de verrouillage réciproque (33) de manière à se projeter depuis une surface de paroi intérieure du moule (60, 61),
la partie de verrouillage réciproque (33) est située sur la surface intérieure du boîtier (10), et
le boîtier (10) est formé par le recouvrement au moins en partie de la partie intérieure (30), excluant sensiblement la partie de verrouillage réciproque (33) par une partie en résine.

2. Article moulé avec insert selon la revendication 1, dans lequel la partie de verrouillage réciproque (33) est formée de manière à se projeter sensiblement vers l'intérieur du boîtier (10) depuis la surface intérieure du boîtier (10).

3. Article moulé avec insert selon l'une ou plus des revendications précédentes, dans lequel l'élément d'insert (20) inclut une barre collectrice (20) qui peut être connectée électriquement à une partie de conducteur d'une carte à circuits imprimés ou bien un composant électrique ou électronique adapté au moins en partie dans le boîtier (10).

4. Article moulé avec insert selon l'une ou plus des revendications précédentes, dans lequel la partie de verrouillage réciproque (33) est constituée d'un matériau de résine synthétique.

5. Article moulé avec insert selon l'une ou plus des revendications précédentes, dans lequel un des composants parmi la partie de verrouillage réciproque (33) et le moule (60, 61) comprend une rainure (34) et dans lequel l'autre des composants parmi la partie de verrouillage réciproque (33) et le moule (60, 61) comprend une projection (63) pouvant être engagée avec la rainure (34).

6. Article moulé avec insert selon l'une ou plus des revendications précédentes, dans lequel un ou plusieurs évidements (32) qui ont sensiblement une section transversale en forme de L sont ménagés sur une ou plusieurs parties de coin de la partie intérieure (30).

7. Article moulé avec insert selon la revendication 6, dans lequel deux évidements sensiblement en forme de L (32) sont ménagés sur un premier coin et sur un second coin sensiblement opposé diagonalement au premier coin de la partie intérieure (30).

8. Méthode de fabrication pour un article moulé avec insert (IMA) prévu avec un boîtier (10) formé par le moulage d'insert utilisant une partie intérieure (30) qui maintient au moins un élément d'insert (20) comme un insert, la méthode comprenant les étapes suivantes :
l'accrochage d'une partie de verrouillage réciproque (33) prévue sur la partie intérieure (30) dans un moule (60, 61) pour le moulage du boîtier (10), permettant ainsi le positionnement et le soutien de la partie intérieure (30) dans le moule (60, 61) de manière à se projeter depuis une surface de paroi intérieure du moule (60, 61), et
l'exécution du moulage de l'insert dans cet état, formant de cette manière le boîtier (10) dans lequel la partie de verrouillage réciproque (33) est située sur la surface intérieure de celui-ci et dans lequel la partie intérieure (30) qui rejette sensiblement la partie de verrouillage réciproque (33) est couverte au moins en partie par une partie en résine.

9. Méthode selon la revendication 8, dans laquelle une rainure (34) prévue sur un des composants parmi la partie de verrouillage réciproque (33) et le moule (60, 61) est engagée dans l'étape d'accrochage avec une projection (63) prévue sur l'autre des composants parmi la partie de verrouillage réciproque (33) et le moule (60, 61).

10. Méthode selon l'une ou l'autre des revendication 8 et 9, dans laquelle la partie de verrouillage réciproque (33) est maintenue fermement dans ou pendant l'étape de moulage de l'insert entre un premier élément de moule (60) et un second élément de moule (61) et/ou se projette au moins en partie dans une cavité (66) où le matériau de moulage est rempli au moins en partie.
